# EUROPEAN PATENT APPLICATION

(11) **EP 4 836 300 A1**
(43) Date of publication of application: **04.11.2026**
(21) Application number: 25172818.4
(22) Date of filing: 28.04.2025
(51) Int. Cl.: H03K 17/955, H03K 17/975, H03K 17/96

(54) **HANDHELD POWER TOOL**

(71) Applicant: Hilti Aktiengesellschaft, 9494 Schaan (LI)
(72) Inventor: Lacher, Michael, 86830 Schwabmünchen (DE); Koschel, Christian, 86199 Augsburg (DE); Huch, Paul, 87656 Germaringen (DE)
(74) Representative: Hilti Aktiengesellschaft Corporate Intellectual Property

(57) **Abstract**

A handheld power tool of the present invention comprises a housing, having provided therein a drive apparatus and a control apparatus for controlling the drive apparatus, and at least one capacitive sensor unit is provided on the housing. The capacitive sensor unit comprises a conductive layer that is electrically connected to the control apparatus and a deformable insulating layer that is disposed on the conductive layer, wherein the insulating layer deforms toward the conductive layer when subjected to a force of an external object. The capacitive sensor unit of the present invention, by deformation of the insulating layer, provides a user with haptic feedback. Moreover, touch and contact force will be sensed in a single signal, which will further improve the sensing capability of the power tool for a real user.

## Description

### TECHNICAL FIELD

The present invention relates to a power tool, and especially relates to a hand-held power tool installed with a capacitive sensor unit.

### BACKGROUND ART

A hand-held power tool designed to have a capacitive sensor is already known in practice. With the help of a capacitive sensor, for example, a power switch may be activated, and then a drive apparatus may be turned on by means of a switch actuated by a user. A capacitive sensor, for example, is arranged in a gripping part of a power tool, and may detect a user's hand on the gripping part.

One of the characteristic properties of a capacitive touch sensor system is that it is basically working without any moving mechanical parts. Independent if it is a self-capacitive or a mutual sensor system the second electrode is always build by the object to be detected (e.g. hand, finger). This is a great advantage in the flexibility to implement such sensor systems, but also a major different to classic switches. Which are having a mechanical actuation and giving haptic feedback to the operator.

In the state of the art this missing haptic is added bay an additional mechanical spring / actuation part on top of the sensor element. The only reason is here to add and provide haptic feedback to the operator. These mechanical solutions come often with the disadvantage of having air cavities which could be filled by e.g. water which will negatively influence the sensor performance.

Further there are capacitive sensor elements in the state of the art known, where also the second electrode is implemented as a conductive layer. In this kind of solutions often a (mechanical) spring structure is built in-between both sensor electrodes.

### SUMMARY OF THE INVENTION

An object of the present invention is to provide a handheld power tool, which has an improved capacitive sensor unit, ensuring insulation performance of a sensor conductive electrode, improving the sensitivity of the capacitive sensor unit, and providing a user with haptic feedback of the capacitive sensor unit.

A handheld power tool of the present invention comprises a housing, having provided therein a drive apparatus and a control apparatus for controlling the drive apparatus, and at least one capacitive sensor unit is provided on the housing. The capacitive sensor unit comprises a conductive layer that is electrically connected to the control apparatus and a deformable insulating layer that is disposed on the conductive layer, wherein the insulating layer deforms toward the conductive layer when subjected to a force of an external object. In the handheld power tool designed according to the present invention, a user applies an external force to the insulating layer of the capacitive sensor unit, and the insulating layer deforms under the force, causing the insulating layer to be displaced relative to the conductive layer, providing haptic feedback for the user. Moreover, touch and contact force will be sensed in a single signal, which will further improve the sensing capability of the power tool for a real user.

According to an embodiment of the present invention, the conductive layer is constructed as an electrode of the sensor unit. Therefore, the capacitive sensor unit of the present invention is a self-capacitive touch sensor which use a single sensor electrode to measure the apparent capacitance between the electrode and the DC ground of the touch sensor circuit.

The insulating layer has a first side face that at least partially contacts the conductive layer and a second side face that is exposed on an outer side of the housing, and a deforming part that is arranged between the first side face and the second side face. A flexible deformable insulating layer is added onto the single electrode of the self-capacitive touch sensor, such that the conductive sensor electrode is protected against corrosion by water, mud and dust, ensuring the insulating performance of the self-capacitive touch sensor unit. Further, sensitivity of the capacitive sensor unit to force is increased by means of the deformable flexible structure of the deforming part.

According to one embodiment of the present invention, the deforming part is formed from an elastic material, and, when subjected to an external force, the second side face moves toward the first side face. Thus, the deforming part elastically deforms when subjected to an external force, and recovers its original shape when the external force is removed, so that the capacitive sensor unit of the present invention is able to provide a user with a haptic feedback/feedback.

According to a preferred embodiment of the present invention, the second side face has a wavy shape or a curvy shape. The wavy or curvy second side face becomes flatter when subjected to an external force applied by a user's hand/finger, thus causing the insulating layer to be displaced relative to the conductive layer. In this case of embodiment, the structure of the second side face is directly linked to the softness of the insulating layer. This means by using a significant wavy/ curvy surface structure the insulating layer could become hard without losing the effect of this disclosure.

According to another preferred embodiment of the present invention, the deforming part has multiple compressible air bubbles. The additional force will reduce the volume of the compressible layer, such that the insulating layer moves toward the conductive layer.

According to another preferred embodiment of the present invention, the conductive layer can also elastically deform.

Preferably, the conductive layer can be constructed as at least one hollow circle or hollow square, and, when subjected to pressure, the hollow circle or hollow square compresses and deforms. In the present embodiment, the electrode of the sensor is not constructed as a common flat shape, but rather is a circle or square with a hollow region, such that, when the outer side of the insulating layer of the sensor unit is subjected to an external force, the insulating layer transfers the external force to the conductive layer constructed as a hollow circle or hollow square, and the hollow region effective for sensing is increased, so that the capacity between the user's hand/finger that acts as a second electrode and the first electrode changes, and the sensor unit can detect a touch and contact force signal.

According to an embodiment of the power tool of the present invention, a flexible deformable insulating layer is added onto the single electrode of the self-capacitive touch sensor unit, such that the conductive layer that acts as an electrode is protected against corrosion by water, mud and dust, while a user is provided with a haptic feedback of the capacitive sensor unit. Moreover, the capacitive sensor unit is very sensitive to the action of a user touching (an action of a hand/finger) a surface of the power tool housing. If the user applies extra force to the surface of the housing of the power tool, the deforming part is subjected to a force and elastically deforms, a sensor signal will further change, and the change characterized by such a user operation can be used to enhance user sensing.

The handheld power tool may relate to various handheld power tools, for example a grinder, such as an angle grinder; a saw machine, such as a reciprocating saw, jigsaw, circular saw or chainsaw; a bandsaw; or a drilling machine, chisel hammer, etc.

### BRIEF DESCRIPTION OF THE DRAWINGS

A better understanding of the embodiments mentioned can be gained from the following detailed description with reference to the drawings. It is emphasized that various components are not necessarily drawn to scale. In fact, dimensions may be increased or decreased at will for the purpose of clear description. In the drawings, the same reference signs refer to the same elements.
Fig. 1 is a highly simplified longitudinal sectional view of a handheld power tool designed as an angle grinder.
Fig. 2 is a schematic drawing of a working principle of a self-capacitive touch sensor unit of the present invention.
Figs. 3a and 3b are respectively schematic drawings of a capacitive sensor unit, according to a schematic embodiment of the present invention, when not under an external force and when under an external force.
Figs. 4a and 4b are respectively schematic drawings of a capacitive sensor unit, according to another schematic embodiment of the present invention, when not under an external force and when under an external force.
Figs. 5a and 5b are respectively schematic drawings of a capacitive sensor unit, according to another schematic embodiment of the present invention, when not under an external force and when under an external force.
Figs. 6a and 6b are respectively schematic drawings of a capacitive sensor unit, according to another schematic embodiment of the present invention, when not under an external force and when under an external force.

### DETAILED DESCRIPTION OF EMBODIMENTS

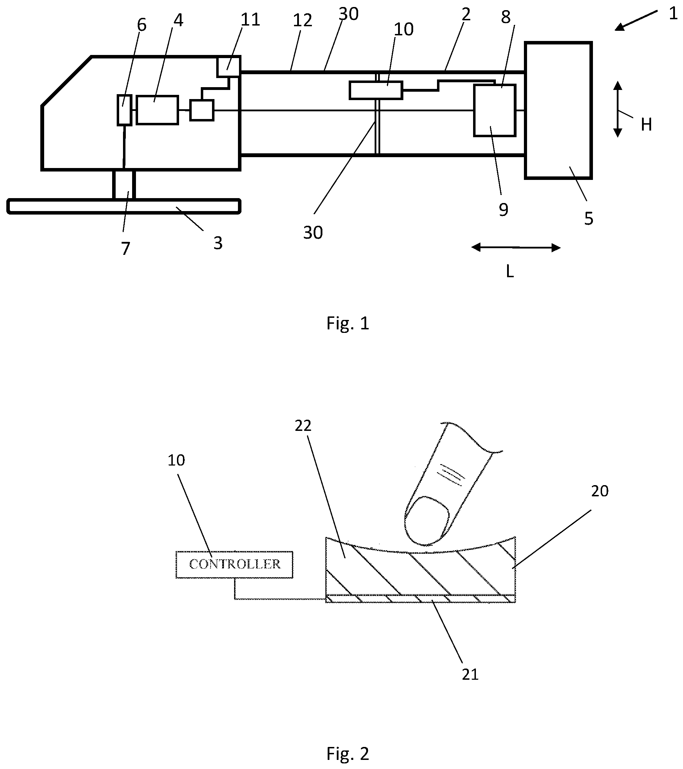

Fig. 1 shows a handheld power tool 1 according to the present invention, designed as an angle grinder in the diagram shown. According to an alternative embodiment, the power tool 1 may also be designed as a drilling machine, hammer drill, saw, plane, screwdriver, milling cutter, severing machine, angle grinder, cutting tool, ceramic tile cutting machine, garden tool and/or multi-functional tool, which can be held by an operator and used for processing workpieces.

The power tool 1, designed as an angle grinder in the drawings, is provided with a housing 2 and a front-end tool 3; this front-end tool, for example, is designed as a cutting disc or abrasive wheel, and may be detachably connected to a driven shaft 7 of the power tool 1. The housing 2 is formed from an insulating plastic, and approximately is a slender tube. The inside of the housing 2 forms a cavity, which is provided with the drive apparatus 4 (e.g. electric motor) for actuating the front-end tool and the control apparatus 8 for controlling the drive apparatus 4. The inside of the housing 2 is further provided with a gear mechanism 6, and the drive apparatus 4 designed as an electric motor is arranged inside the housing 2 together with the gear mechanism 6. The drive apparatus 4, the gear mechanism 6 and the driven shaft 7 to which the front-end tool is operably connected are arranged relative to each other and interconnected, such that torque generated by the electric motor may be transferred to the gear mechanism 6, and finally to the driven shaft 7. In addition, the power tool 1 is supplied with current by a storage battery 5 which may be connected to the housing 2. Alternatively, the power tool 1 also may be supplied with current from a network with the aid of a power cable.

In the exemplary power tool of the figures, the control apparatus 8 is designed to have a main control electronic device 9 and control element 10. The control element 10 is preferably designed as a printed circuit board, and is electrically and electronically connected to the main control electronic device 9, and the main control electronic device 9, in the current scenario, is arranged in a region of the storage battery 5. A power switch actuatable by a user by means of the switch 11 is also connected to the main control electronic device 9. The power switch, for example, is designed as a MOSFET and is configured so that current can flow from the storage battery 5 to the drive apparatus 4.

The housing 2 is provided with at least one gripping part 12, provided for a user to control and guide the power tool 1 with one or both hands. When the power tool 1 is controlled with the gripping part 12, a user operable switch 20 is associated with a control region 12. At least one sensor unit 20 is integrated on the housing 2, and, preferably, the sensor unit 20 is configured to linearly extend along the gripping part region. The sensor unit 20 is fixedly mounted on the housing 2; for example, the sensor unit 20 comprises a substrate wrapped in insulating plastic of the housing 2. The housing 2 may act as a base plate of the sensor unit. It should be explained that the sensor unit 20 may also have a base plate that is independent from the housing, wherein the base plate is further mounted on the housing 2.

Fig. 2 shows a schematic drawing of a working principle of a capacitive sensor unit of the present invention in a greatly simplified manner. According to the present invention, the capacitive sensor unit 20 is designed as a self-capacitive touch sensor, which has a single sensor electrode, which measures a change in capacitance between the single electrode and a ground electrode of a sensor circuit. The capacitive sensor unit 20 comprises a conductive layer 21 that is electrically connected to the control apparatus 8 and a deformable insulating layer 22 that is disposed on the conductive layer. The conductive layer 21 can be directly mounted on the housing 2, and the portion of the housing 2 that is used for supporting the conductive layer 21 acts as a base plate 23 of the sensor unit. In the present invention, the conductive layer 21 forms a single electrode of the self-capacitive sensor unit, and a user's hand/finger can be seen as a ground electrode, and is it not necessary to additionally provide a second electrode. Thus, the complexity of designing and installing the sensor unit is greatly reduced, thereby clearly reducing manufacturing costs and simplifying processes.

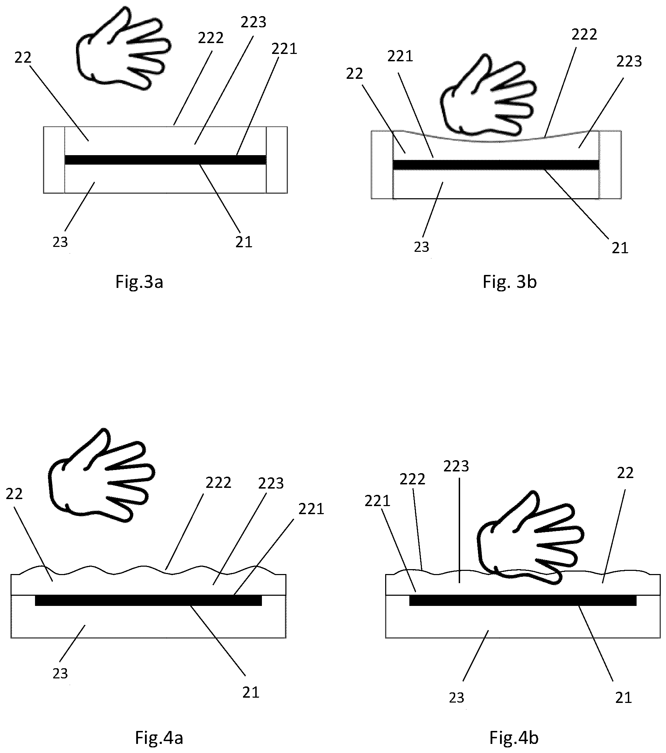

Referring to Figs. 3a to 6b, the insulating layer 22 has a first side face 221 that at least partially contacts the conductive layer 21 and a second side face 222 that faces an outer side of the housing, and a deforming part 223 that is arranged between the first side face and the second side face. A flexible deformable insulating layer is added onto the single electrode of the self-capacitive sensor, such that the conductive sensor electrode is protected against corrosion by water, mud and dust. Moreover, the capacitive sensor unit is very sensitive to the action of a user touching (an action of a hand/finger) a surface of the power tool housing. If the user applies extra force to the surface of the housing 2 of the power tool, the deforming part 223 is subjected to a force and elastically deforms, a sensor signal will further change, and the change characterized by such a user operation can be used to enhance user sensing. In addition, the deforming part 223 elastically deforms when subjected to an external force, and recovers its original shape when the external force is removed, so that the capacitive sensor unit of the present invention is able to provide a user with haptic feedback.

Referring to Figs. 3a and 3b, according to an embodiment of the present invention, the deforming part 223 is formed from an elastic material, and, when subjected to pressure, the second side face 222 moves toward the first side face 221 that coincides with the conductive layer 21. As shown in Fig. 3a, when not subjected to an external force applied by an external object, such as a user's hand/finger, that is, a user's hand does not grip the power tool 1, a sensor unit that is arranged on the housing 2 is not contacted by the user, and, in this case, the sensor unit 30 does not detect information of a corresponding capacitance change. When the user's hand grips the gripping part of the power tool 1, the user's hand/finger approaches and contacts an outer surface of the housing 2, at which time the second side face 222 of the insulating layer that is exposed on an outer side of the housing is contacted by the user's hand/finger, and, when gripping the power tool 1, the finger necessarily applies an external force to the second side face 222 to be able to control the power tool 1. Since formed from an elastic material, the deforming part 223 will deform toward the first side face 221 when subjected to an external force, and therefore the distance between the deforming part and the second side face 222 in contact with the finger, and the distance between the deforming part and the first side face 221 in contact with the conductive layer 21 change, and the capacitance between the finger acting as the ground electrode and the single electrode also changes, so that the sensor unit 20 senses a gripping and touch signal of the user.

The self-capacitive sensor unit according to an embodiment of the present invention is very sensitive to a user touching (an action of a hand/finger approaching) a surface of the power tool. If the user applies extra force to an outer surface of a housing of a power tool fitted with the sensor unit, a signal of the sensor unit will further change. Signals of the sensor unit include touch and force information. The haptic feedback of a user of a power tool, particularly a gripping force, changes during application on a working surface. Such a characteristic change of a user can be used for enhancing user sensing, and the behaviour of the power tool can be adjusted according to user sensing information, for example, speed reduction, turning off a switch, fast turn off, etc.

Referring to Figs. 4a and 4b, according to a preferred embodiment of the present invention, the second side face 222 has a wavy shape or a curvy shape. As shown in Fig. 4a, when not subjected to an external force applied by an external object, such as a hand/finger, the second side face 222 has a wavy shape. As shown in Fig. 4b, the wavy or curvy second side face 222 becomes flatter when subjected to an external force applied by a user's hand/finger, thus causing the insulating layer 22 to be displaced relative to the conductive layer 21. When the user's hand/finger departs from the gripping region, the second side face 222 is no longer subjected to an external force, and, under the effect of the deforming part 223 made from an elastic material, again recovers the wavy shape or curvy shape shown in Fig. 4a. It is desirable for the second side face 222 to be exposed on the outer side of the housing 2 but not to be obviously higher than the outer side of the housing 2, and preferably the second side face 222 remains flush with the outer side face of the housing 2. Therefore, the second side face 222, constructed as a wavy shape or curvy shape, can be configured as a shape that matches the outer contour of the housing 2.

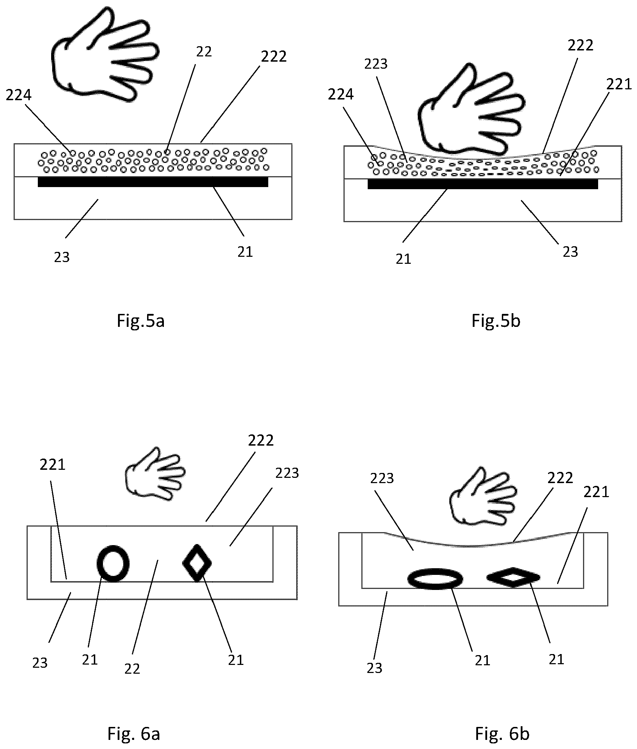

Referring to Figs. 5a and 5b, according to another preferred embodiment of the present invention, the deforming part 223 has multiple compressible air bubbles 224. The additional force will reduce the volume of the compressible layer, such that the insulating layer moves toward the conductive layer. In the present embodiment, the deforming part 223 itself does not need to have high elasticity, rather the inside of the deforming part 223 deforms when the air bubbles 224 compress, such that the second side face 222 moves toward the first side face 221, thereby forming a change in capacitance of the sensor unit.

Referring to Figs. 6a and 6b, according to another preferred embodiment of the present invention, the conductive layer 21 can also elastically deform. In the present embodiment, not only can the deforming part 223 deform when subjected to an external force, but the conductive layer 21 acting as a conductive electrode can also elastically deform. Preferably, it is as shown in Fig. 6a. The conductive layer 21 can be constructed as at least one hollow circle or hollow square. As shown in Fig. 6b, when the second side face 222 of the insulating layer 22 of the sensor unit 20 is subjected to an external force, the insulating layer 22 transfers the external force to the conductive layer 21 constructed as a hollow circle or hollow square, and the hollow region is compressed, so that the displacement between the user's hand/finger that acts as a second electrode and the single electrode changes, and the sensor unit 30 can detect a touch and contact force signal.

As stated above, although exemplary embodiments of the present invention have been explained herein with reference to the drawings, the present invention is not limited to the specific embodiments above, and could have many other embodiments. The scope of the present invention shall be defined by the claims and their equivalents.

## Claims

1. Handheld power tool (1), comprising a housing (2), with a drive apparatus (4) and a control apparatus (8) for controlling the drive apparatus (4) provided therein, and at least one capacitive sensor unit (20) is provided in the housing (2), **characterized in that** the capacitive sensor unit (20) comprises a conductive layer that is electrically connected to the control apparatus and a deformable insulating layer that is disposed on the conductive layer, wherein the insulating layer deforms toward the conductive layer when subjected to a force of an external object.

2. Handheld power tool according to Claim 1, **characterized in that** the conductive layer is constructed as an electrode of the sensor unit.

3. Handheld power tool according to Claim 1, **characterized in that** the insulating layer has a first side face that at least partially contacts the conductive layer and a second side face that faces an outer side of the housing, and a deforming part that is arranged between the first side face and the second side face.

4. Handheld power tool according to Claim 3, **characterized in that** the deforming part is formed from an elastic material, and, when subjected to an external force, the second side face moves toward the first side face.

5. Handheld power tool according to Claim 3, **characterized in that** the second side face has a wavy shape or curvy shape.

6. Handheld power tool according to Claim 4, **characterized in that** the deforming part has multiple compressible air bubbles.

7. Handheld power tool according to any one of the preceding claims, **characterized in that** the conductive layer can also elastically deform.

8. Handheld power tool according to Claim 7, **characterized in that** the conductive layer is formed from a conductive elastic material.

9. Handheld power tool according to Claim 7, **characterized in that** the conductive layer can be constructed as at least one hollow circle or hollow square, and, when subjected to pressure, the hollow circle or hollow square compresses and deforms.
